# FASCICULE DE BREVET EUROPEEN

(11) **EP 1 494 521 B1**
(45) Date de publication et mention de la délivrance du brevet: **22.12.2010**
(21) Numéro de dépôt: 04291313.7
(22) Date de dépôt: 24.05.2004
(51) Int. Cl.: H05K 9/00, F21V 25/00

(54) **Actionneur équipé d'une carte électronique avec agencement de limitation des radiations électromagnétiques**
Stellantrieb ausgerüstet mit einer elektronischen Leiterplatte mit einer Anordnung zur begrenzung der elektromagnetischen Ausstrahlung
Actuator equipped with an electronic card with device for limit electromagnetic radiation

(30) Priorité: 26.05.2003 FR 0306355
(43) Date de publication de la demande: 05.01.2005
(73) Titulaire: VALEO VISION, 93012 Bobigny Cedex (FR)
(72) Inventeur: Cara, Hervé, 94440 Villescrenes (FR); Delabriere, Stéphane, 76160 Saint Léger du Bourg Denis (FR)
(74) Mandataire: Tran, Chi-Hai

(56) Documents cités:
- US-A1- 2002 098 726
- US-A1- 2002 118 517
- US-B1- 6 390 657

## Description

La présente invention concerne un actionneur équipé d'une carte électronique avec agencement de limitation des radiations électromagnétiques. Elle s'applique en particulier à un actionneur destiné à actionner un réflecteur de projecteur de véhicules automobiles.

Des signaux électromagnétiques à haute fréquence sont générés durant le fonctionnement d'un circuit électrique par exemple contenant un oscillateur à haute fréquence. Ces signaux sont produits lors du fonctionnement normal d'un circuit électrique et sont indésirables car peuvent interférer avec le fonctionnement normal d'un autre circuit électrique. Cette interférence et ses effets néfastes sont bien connus des utilisateurs d'équipements électroniques.

Afin de minimiser ces signaux indésirables, il est connu de blinder des portions du circuit électronique en question avec un écran conducteur à un potentiel faible ou au potentiel de masse. Cet écran électromagnétique à la masse absorbe le champ électromagnétique. Ainsi dans le cas d'une carte électronique, il est connu de souder un blindage électromagnétique à la piste de masse de la carte formée sur la carte électronique. Cependant, un tel agencement rend une inspection ou une réparation de la carte pratiquement impossible.

Par ailleurs, dans une application particulière concernant un actionneur de réflecteur de projecteur de véhicules automobiles, un agencement connu consiste à monter dans un boîtier commun un moteur pas à pas et une carte électronique de commande. Afin de permettre montage et démontage de cette carte, cette dernière est montée sur des glissières agencées sur le carter à proximité du moteur, par insertion de type tiroir.

La commande d'un moteur pas à pas par exemple à deux phases entraîne en mode courant de fortes perturbations électromagnétiques dites CEM (Compatibilité Electromagnétique) à cause du découpage de la tension et de l'alimentation.

Il est connu d'utiliser le carter du moteur en tant que blindage à la masse. Cette mise à la masse est réalisée par un fil électrique dit 5^{e} fil, monté côté carte électronique sur un connecteur de la carte comportant une connexion à la piste de masse et côté moteur sur une connexion reliée par une languette sertie sur le carter. Cette connexion côté moteur porte également les quatre connexions de transmission de signaux nécessaire à la commande.

Cette solution pose les problèmes techniques suivants.

Elle suppose tout d'abord la présence d'un connecteur côté carte électronique portant une connexion à la piste de masse.

Et surtout, la connexion dite à cinq fils sur le moteur est un agencement spécifique du moteur. En d'autres termes, un moteur standard pas à pas quatre phases comporte une connexion à quatre fils sans liaison électrique au carter et dans le cas d'un montage de moteur standard, cette solution ne peut être envisagée.

De façon plus générale, quel que soit le moteur standard sans connecteur avec liaison électrique au carter, cette solution ne peut être appliquée.

Or, les exigences de compatibilité électromagnétique deviennent de plus en plus importantes dans ce type de matériel.

Pour résoudre ce problème, l'invention propose un actionneur selon la revendication 1. Le mode de réalisation le plus simple consiste à ce que la liaison électrique entre le carter et la partie de masse soit assurée uniquement par un élément déformable et conducteur électriquement. Mais on peut aussi avoir une liaison électrique assurée par une pluralité d'éléments conducteurs parmi lesquels il y a au moins un élément déformable. C'est notamment utile quand la configuration du produit est telle que l'élément déformable est trop distant du carter moteur. Il faut assurer alors de façon appropriée la continuité électrique entre carter et partie de masse avec l'agencement d'éléments conducteurs ad hoc.

L'agencement conforme à l'invention permet d'obtenir une bonne efficacité de compatibilité électromagnétique, tout en pouvant être adaptée à tout type de moteur et à tout type de carte électronique de commande.

L'invention présente également les avantages suivants.

Un autre effet du fonctionnement d'un circuit électrique est l'énergie thermique. Si elle n'est pas dissipée, la montée en chaleur peut entraîner un mauvais fonctionnement de la carte électronique et peut même endommager les composants de la carte. Ledit élément déformable conducteur assure la compatibilité électromagnétique tout en assurant un drain thermique favorable à la dissipation thermique.

Par contre, le fait d'utiliser ce blindage permet de travailler avec des fronts de découpage plus rapide et ainsi de minimiser les pertes à la commutations. Cette optimisation de la thermique facilite la réduction de taille du boitier du composant driver de moteur donc influe sur le coût du boitier.

Par ailleurs, il est important de conserver un encombrement réduit de l'ensemble moteur et carte électronique. L'invention permet d'obtenir ou de conserver une taille optimale du boîtier d'actionneur et donc une excellente intégration.

Selon un mode de réalisation préféré, ledit élément déformable est fixé sur la piste de masse de ladite carte électronique.

De préférence, ledit élément déformable comprend au moins une languette flexible. Avantageusement, il est constitué d'une seule languette.

L'invention s'applique particulièrement à un tel actionneur dont la carte électronique de commande est mise en place à proximité du moteur sur des glissières solidaires du boîtier par un emboîtement de type tiroir, caractérisé en ce que ladite carte porte ladite languette flexible conductrice fixée sur sa piste de masse, la languette étant conformée de façon à venir en contact avec déformation sur le carter du moteur par emboîtement de la carte dans lesdites glissières.

Selon un mode de réalisation préféré, ladite languette présente un profil en forme de Z, dont la branche inférieure est fixée dur la piste de masse.

De préférence, la branche supérieure de la languette venant en contact avec le carter du moteur est pourvue d'au moins une fente longitudinale afin d'absorber les contraintes de positionnement relatif de la languette par rapport à la zone de contact du moteur.

Une zone plan est prévue pour la préhension de la languette par des machine de pose de composants CMS en automatique. Le conditionnement de la languette est ciblé en bande compatible avec les lignes de pose automatiques.

Avantageusement, la languette est soudée sur la piste de masse de la carte électronique.

L'application préférée de l'invention est un tel actionneur destiné à actionner un réflecteur de projecteur de véhicule automobile.

L'invention est décrite ci-après plus en détail à l'aide de figures ne représentant qu'un mode de réalisation préféré de l'invention.

La figure 1 est une vue en perspective d'une carte électronique de commande conforme à l'invention.

Les figures 2 et 3 sont des vues partielles en perspective d'un actionneur conforme à l'invention, lors du montage de la carte électronique de commande.

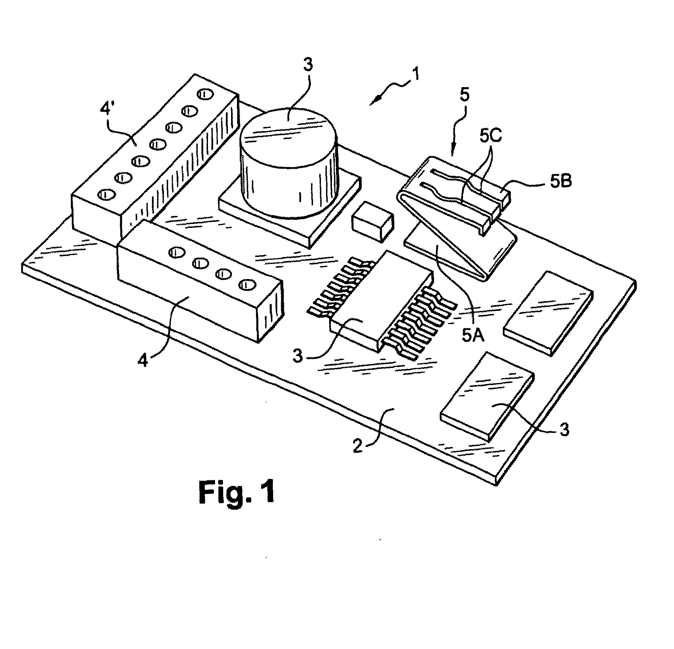

Une carte électronique 1 comme représentée sur la figure 1 comporte de façon connue un substrat isolant 2 pourvu de pistes conductrices non représentées reliant divers composants électroniques 3 ainsi que deux connecteurs 4, 4'. Cette carte 1 comporte une piste de masse sur laquelle est fixé, de préférence par soudure, un élément déformable conducteur 5 constitué d'une languette flexible conductrice.

Cette languette 5 présente un profil en forme de Z, dont la branche inférieure 5A est soudée sur la piste de masse et la branche supérieure 5B est pourvue d'au moins une fente longitudinale 5C, ici précisément deux fentes 5C dont la fonction sera explicitée plus loin.

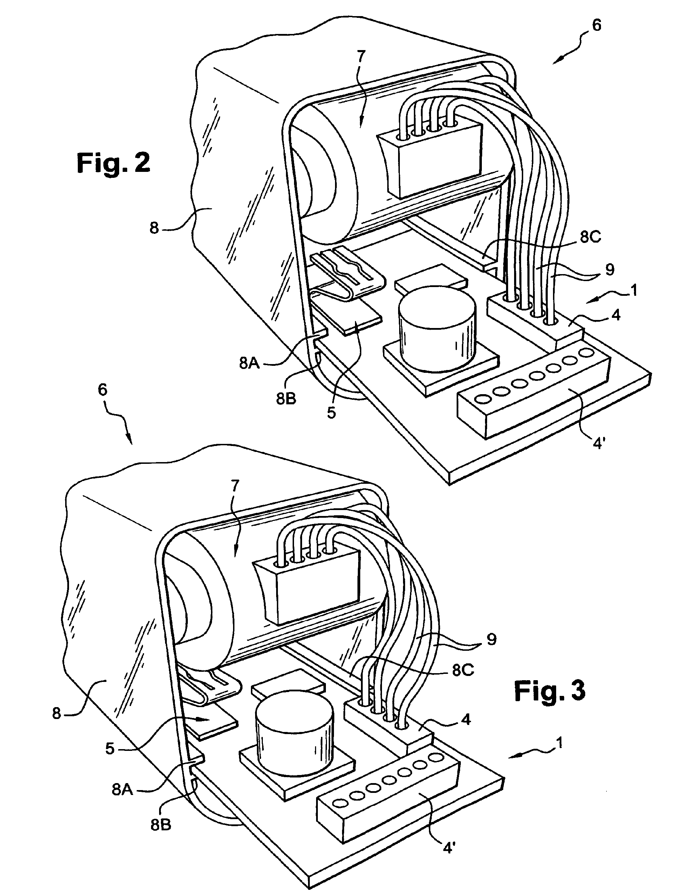

Une telle carte électronique est destinée à un actionneur 6 représenté en partie sur les figures 2 et 3. Un tel actionneur est destiné à actionner un réflecteur de projecteur de véhicule automobile.

Cet actionneur comporte dans un boîtier commun 8 un moteur contenu dans un carter métallique 7 et une telle carte électronique 1 de commande de ce moteur mise en place à proximité du moteur 7 sur des glissières 8A, 8B, 8C solidaires du boîtier 8 par un emboîtement de type tiroir. La carte 1 est mise en place avec son connecteur 4 destiné à la connexion de commande avec le moteur dirigé vers l'extérieur afin de permettre la connexion des quatre fils 9 de commande du moteur qui est ici un moteur pas à pas deux phases.

Lors de l'insertion de la carte 1 sur les glissières, la branche supérieure 5B de la languette 5 est poussée vers le bas, vue selon les figures, et vient donc s'appliquer avec une contrainte de poussée contre le carter du moteur 7. Il est ainsi assuré un excellent contact entre la languette 5 et le carter. La déformation de la languette 5 assure par contact la liaison électrique entre le carter et la partie de masse de la carte 1.

La fonction des fentes 5C portées par cette branche 5B apparaît sur les figures 2 et 3. De façon générale, la piste de masse de la carte 1 est à proximité d'un bord de la carte. Selon la disposition relative des différents éléments, compte tenu de la conformation en tiroir, la branche 5B peut se placer donc sur un bord du carter du moteur 7 avec uniquement une partie en contact avec ce dernier. Grâce à l'agencement de fentes 5C, seule une partie de la branche 5B disposée entre un bord de cette branche et une fente 5C est déformée. Ainsi est limitée l'effort de déformation.

Un mode de réalisation préféré est ci-dessus décrit mais l'invention concerne tout mode de réalisation équivalent.

La languette en Z déformable 5 peut être de toute autre forme, le but étant d'assurer par sa déformation la liaison électrique entre le carter et la partie de masse par contact.

Cet élément déformable 5 peut être constitué d'une languette flexible comme décrit précisément. Il peut également être constitué d'un contact de connectique à ressort de type plot coulissant.

La fonction de cet élément déformable 5 est d'assurer la liaison électrique du carter à une partie de masse. Selon le mode de réalisation préféré, c'est la piste de masse de la carte électronique qui est choisie. Il peut également être envisagé de disposer cet élément de contact entre le carter du moteur et le boîtier de l'actionneur.

Par ailleurs cet élément déformable 5 peut être fixé à la carte électronique comme décrit dans le mode de réalisation préféré ou fixé sur le boîtier d'actionneur, par exemple par surmoulage, ou même sur le carter du moteur.

Le choix de la matière est guidé par les propriétés ressort de la matière et par sa soudabilité (pré étamage). A titre d'exemple, on peut utiliser du bronze phosphoreux, du type CuSn9P à l'état S14 de par exemple environ 0.2mm d'épaisseur.

L'invention porte également sur le projecteur équipé de l'actionneur selon l'invention, et sur le véhicule automobile équipé de ce type de projecteur.

## Revendications

1. Actionneur comportant dans un boîtier commun (8) un moteur (7) contenu dans un carter métallique et une carte électronique de commande (1) portant un élément déformable (5) fixé sur sa piste de masse, **caractérisé en ce que** la carte électronique de commande (1) est mise en place à proximité du moteur (7) sur des glissières (8A, 8B, 8C) solidaires du boîtier (8) par un emboîtement de type tiroir, et que l'élément déformable (5) est conformé de façon à venir en contact avec déformation sur le carter du moteur (7) par l'emboîtement de la carte dans lesdites glissières (8A, 8B, 8C) pour assurer une liaison électrique entre ledit carter métallique et ladite piste de masse.

2. Actionneur selon la revendication 1, **caractérisé en ce que** la liaison électrique est réalisée par l'élément déformable (5) ainsi que par au moins un autre élément.

3. Actionneur selon l'une des revendications précédentes, **caractérisé en ce que** ledit élément déformable (5) comprend au moins un contact connectique à ressort du type plot coulissant.

4. Actionneur selon l'une des revendications précédentes, **caractérisé en ce que** ledit élément déformable (5) comprend au moins une languette flexible conductrice.

5. Actionneur selon la revendication 4, **caractérisé en ce que** ladite carte électronique (1) porte ladite languette flexible conductrice (5) fixée sur sa piste de masse, la languette étant conformée de façon à venir en contact avec déformation sur le carter du moteur (7) par emboîtement de la carte dans les glissières (8A, 8B, 8C).

6. Actionneur selon la revendication 4 ou 5 , **caractérisé en ce que** ladite languette présente un profil en forme de Z, dont la branche inférieure (5A) est fixée sur la piste de masse.

7. Actionneur selon la revendication 6, **caractérisé en ce que** la branche supérieure (5B) de la languette venant en contact avec le carter du moteur est pourvue d'au moins une fente longitudinale (5C).

8. Actionneur selon l'une des revendications 4 à 7, **caractérisé en ce que** la languette (5) est soudée sur la piste de masse de la carte électronique (1).

9. Actionneur selon l'une des revendications 4 à 8, destiné à actionner un réflecteur de projecteur de véhicule automobile.

10. Projecteur de véhicule automobile équipé de l'actionneur selon l'une des revendications précédentes.

11. Véhicule automobile équipé d'un ou plusieurs projecteurs selon la revendication 10.

## Claims

1. Actuator comprising in a common case (8) a motor (7) which is contained in a metal housing and an electronic control board (1) which bears a deformable element (5) which is secured to its earthing track, **characterised in that** the electronic control board (1) is put into place in the vicinity of the motor (7) on slides (8A, 8B, 8C) which are rendered integral with the case (8) by nesting of the slide type, and the deformable element (5) is formed such as to come into contact, with deformation, on the housing of the motor (7) by means of the nesting of the board in the said slides (8A, 8B, 8C), in order to assure an electrical connection between the said metal housing and the said earthing track.

2. Actuator according to claim 1, **characterised in that** the electrical connection is provided by the deformable element (5), as well as by at least one other element.

3. Actuator according to one of the preceding claims, **characterised in that** the said deformable element (5) comprises at least one spring connection contact of the sliding pin type.

4. Actuator according to one of the preceding claims, **characterised in that** the said deformable element (5) comprises at least one conductive flexible tongue.

5. Actuator according to claim 4, **characterised in that** the said electronic board (1) bears the said conductive flexible tongue (5) which is secured to its earthing track, the tongue being formed such as to come into contact with deformation on the housing of the motor (7) by nesting of the board in the slides (8A, 8B, 8C).

6. Actuator according to claim 4 or 5, **characterised in that** the said tongue has a profile in the form of a Z, the lower branch (5A) of which is secured to the earthing track.

7. Actuator according to claim 6, **characterised in that** the upper branch (5B) of the tongue which comes into contact with the housing of the motor is provided with at least one longitudinal slot (5C).

8. Actuator according to one of claims 4 to 7, **characterised in that** the tongue (5) is soldered onto the earthing track of the electronic board (1).

9. Actuator according to one of claims 4 to 8, which is designed to actuate a reflector of a motor vehicle headlight.

10. Motor vehicle headlight equipped with the actuator according to one of the preceding claims.

11. Motor vehicle equipped with one or a plurality of headlights according to claim 10.

## Patentansprüche

1. Stellorgan, mit einem in einem Metallgehäuse enthaltenen Motor (7) und einer elektronischen Steuerplatine (1), die ein auf ihrer Masseleiterbahn befestigtes verformbares Element (5) trägt, in einem gemeinsamen Gehäuse (8),
**dadurch gekennzeichnet, dass** die elektronische Steuerplatine (1) in der Nähe des Motors (7) durch Einstecken vom Typ Einschub auf Gleitschienen (8A, 8B, 8C), die fest mit dem Gehäuse (8) verbunden sind, angebracht ist, und dass das verformbare Element (5) solchermaßen ausgebildet ist, dass es durch das Einstecken der Platine in die Gleitschienen (8A, 8B, 8C) durch Verformung am Gehäuse des Motors (7) in Kontakt gelangt, um zwischen dem Metallgehäuse und der Masseleiterbahn eine elektrische Verbindung herzustellen.

2. Stellorgan nach Anspruch 1,
**dadurch gekennzeichnet, dass** die elektrische Verbindung durch das verformbare Element (5) sowie durch mindestens ein weiteres Element erfolgt.

3. Stellorgan nach einem der vorhergehenden Ansprüche,
**dadurch gekennzeichnet, dass** das verformbare Element (5) wenigstens einen Anschlusskontakt vom Typ Gleitkontaktstift aufweist.

4. Stellorgan nach einem der vorhergehenden Ansprüche,
**dadurch gekennzeichnet, dass** das verformbare Element (5) wenigstens eine leitende elastische Zunge aufweist.

5. Stellorgan nach Anspruch 4,
**dadurch gekennzeichnet, dass** die elektronische Platine (1) die leitende elastische Zunge (5) auf ihrer Masseleiterbahn befestigt trägt, wobei die Zunge solchermaßen ausgebildet ist, dass sie durch Einstecken der Platine in die Gleitschienen (8A, 8B, 8C) durch Verformung am Gehäuse des Motors (7) in Kontakt gelangt.

6. Stellorgan nach Anspruch 4 oder 5,
**dadurch gekennzeichnet, dass** die Zunge ein Z-förmiges Profil aufweist, deren unterer Schenkel (5A) auf der Masseleiterbahn befestigt ist.

7. Stellorgan nach Anspruch 6,
**dadurch gekennzeichnet, dass** der mit dem Gehäuse des Motors in Kontakt gelangende obere Schenkel (5B) der Zunge mit wenigstens einem Längsschlitz (5C) versehen ist.

8. Stellorgan nach einem der Ansprüche 4 bis 7,
**dadurch gekennzeichnet, dass** die Zunge (5) auf die Masseleiterbahn der Platine (1) gelötet ist.

9. Stellorgan nach einem der Ansprüche 4 bis 8,
das dazu bestimmt ist, einen Reflektor eines Kraftfahrzeugscheinwerfers zu betätigen.

10. Kraftfahrzeugscheinwerfer, ausgestattet mit einem Stellorgan nach einem der vorhergehenden Ansprüche.

11. Kraftfahrzeug, ausgestattet mit einem oder mehreren Scheinwerfern nach Anspruch 10.
